Europäisches Patentamt

European Patent Office

Office européen des brevets

(19)

(11) Veröffentlichungsnummer: **0 234 225**
**B1**

(12) **EUROPÄISCHE PATENTSCHRIFT**

(45) Veröffentlichungstag der Patentschrift:
28.03.90

(21) Anmeldenummer: 87100470.1

(22) Anmeldetag: 15.01.87

(51) Int. Cl.⁴: **H01J 37/244**, G01R 31/28

(54) Verfahren und Anordnung zum Nachweis der auf einer Probe von einem primären Korpuskularsträhl ausgelösten Sekundärkorpuskeln.

(30) Priorität: 27.01.86 DE 3602366

(43) Veröffentlichungstag der Anmeldung:
02.09.87 Patentblatt 87/36

(45) Bekanntmachung des Hinweises auf die Patenterteilung:
28.03.90 Patentblatt 90/13

(84) Benannte Vertragsstaaten:
DE FR GB IT NL

(56) Entgegenhaltungen:
WO-A-84/00443

PATENT ABSTRACTS OF JAPAN, Band 6,
Nr. 233 (P-156)[1111], 19. November 1982; &
JP-A-57 133 357 (FUJITSU K.K.) 18-08-1982
PATENT ABSTRACTS OF JAPAN, Band 9,
Nr. 140 (E-321)[1863], 14. Juni 1985; &
JP-A-60 23 944 (HITACHI SEISAKUSHO K.K.) 06-02-1985
PATENT ABSTRACTS OF JAPAN, Band 7,
Nr. 170 (E-189)[1315], 27. Juli 1983; &
JP-A-58 78 355 (AKASHI SEISAKUSHO K.K.) 11-05-1983

(73) Patentinhaber: Siemens Aktiengesellschaft,
Wittelsbacherplatz 2, D-8000 München 2(DE)

(72) Erfinder: Brust, Hans-Detlef, Martin-Luther-Strasse 2,
D-6602 Dudweiler(DE)

ACTORUM AG

## Beschreibung

Die Erfindung betrifft ein Verfahren zum Nachweis der auf einer Probe von einem primären Korpuskularstrahl ausgelösten Sekundärkorpuskeln nach dem Oberbegriff des Patentanspruchs 1, und eine Anordnung zur Durchführung des Verfahrens nach dem Oberbegriff des Patentanspruchs 8.

Trifft ein primärer Kospuskularstrahl auf einen Festkörper, so werden aufgrund der Wechselwirkung der Primärteilchen mit der Festkörpersubstanz Sekundärkorpuskeln emittiert, deren Energie- und Winkelverteilung unter anderem von der im Wechselwirkungsbereich vorliegenden chemischphysikalischen Zusammensetzung, der Oberflächenstruktur und der auf der Probe vorhandenen Potentialverteilung abhängt. Von besonderer Bedeutung für die Abbildung von Oberflächenstrukturen und elektrischen Potentialverteilungen in einen Rasterelektronenmikroskop sind die in oberflächennahen Bereichen ausgelösten Sekundärelektronen, die man überlicherweise mit einem seitlich oberhalb der zu untersuchenden Probe angeordneten Detektor nachweist. Infolge dieser unsymmetrischen Anordnung des üblicherweise aus einem Absaugnetz, einem Szintillator und einem über einen Lichtleiter angekoppelten Photomuliplier bestehenden Detektors innerhalb der Probenkammer, ist die Nachweiswahrscheinlichkeit der Sekundärelektronen stark von deren Emissionswinkel abhängig.

Ein Detektorsystem mit mehreren symmetrisch zur Probe angeordneten Sekundärelektronen-Detektoren ist aus der europäischen Patentschrift 0 018 031 bekannt. Derartige Mehrdetektorsysteme werden vor allem zur Untersuchung großer Proben eingesetzt, um ein weitgehend symmetrisches, vom Emissionsort und Emissionswinkel unabhängiges Absaugen der Sekundärelektronen zu gewährleisten. Symmetrische Dektoranordnungen besitzen allerdings den entscheidenden Nachteil, daß die nahezu in Richtung der Symmetrieachse des Systems emittierten Sekundärelektronen wegen der in diesem Raumbereich vernachlässigbaren Stärke des Absaugfeldes nur schwach abgelenkt und damit nicht nachgewiesen werden. Die Wahrscheinlichkeit der Emission eines Sekundärelektrones in Richtung der Symmetrieachse der Detektoranordnung ist aber wegen der Cosinus-Verteilung der Austrittswinkel sehr hoch.

Der vorliegenden Erfindung liegt die Aufgabe zugrunde, ein Verfahren und eine Anordnung der eingangs genannten Art anzugeben, mit dem man die Richtung, in der die auf einer Probe ausgelösten Sekundärkorpuskeln bevorzugt abgesaugt werden, ohne Änderung der räumlichen Konfiguration des Detektorsystem variieren kann. Es soll insbesondere ein weitgehend winkelunabhängiges und/oder symmetrisches Absaugen der Sekundärkorpuskeln möglich sein, wobei auch die in Richtung der Symmetrieachse des Detektorsystems emittierten Korpuskeln abgelenkt und nachgewiesen werden.

Diese Aufgabe wird erfindungsgemäß durch ein Verfahren nach Patentanspruch 1 und eine Anordnung nach Patentanspruch 8 gelöst.

Der mit der Erfindung erzielbare Vorteil besteht insbesondere darin, daß bei symmetrischen Detektoranordnungen auch die in Richtung der Symmetrieachse des Systems emittierten Sekundärkorpuskeln abgelenkt und nachgewiesen werden. Gegenüber konventionellen Detektorsystemen ist somit ein günstigeres Signal-Rausch-Verhältnis und damit auch eine Steigerung der Meßempfindlichkeit erreichbar.

Die Ansprüche 2 bis 7 sind auf bevorzugte Ausgestaltung des erfindungsgemäßen Verfahrens gerichtet, während die Ansprüche 8 bis 12 Anordnungen zur Durchführung des Verfahrens betreffen. Die Erfindung wird nachfolgend anhand der Zeichnungen näher erläutert. Dabei zeigen:

Fig. 1 und 2 Detektorsysteme zum Nachweis der auf einer Probe ausgelösten Sekundärelektronen,
Fig. 3 und 4 Spannungsverläufe an den Absaugelektroden der Detektorsysteme nach Fig. 1 oder 2,
Fig. 5 ein Meßsystem zur Abbildung einer Probe

Das erfindungsgemäße Verfahren wird nachfolgend am Beispiel eines Detektorsystems zum Nachweis der auf einer Probe von einem Primärelektronenstrahl ausgelösten Sekundärelektronen beschrieben. Als Primär- und Sekundärkorpuskel können außer Elektronen selbstverständlich auch andere geladene Teilchen beispielsweise Ionen in Betracht kommen. Das Detektorsystem ist dann den für die jeweiligen Sekundärkorpuskel spezifischen Nachweismethoden anzupassen.

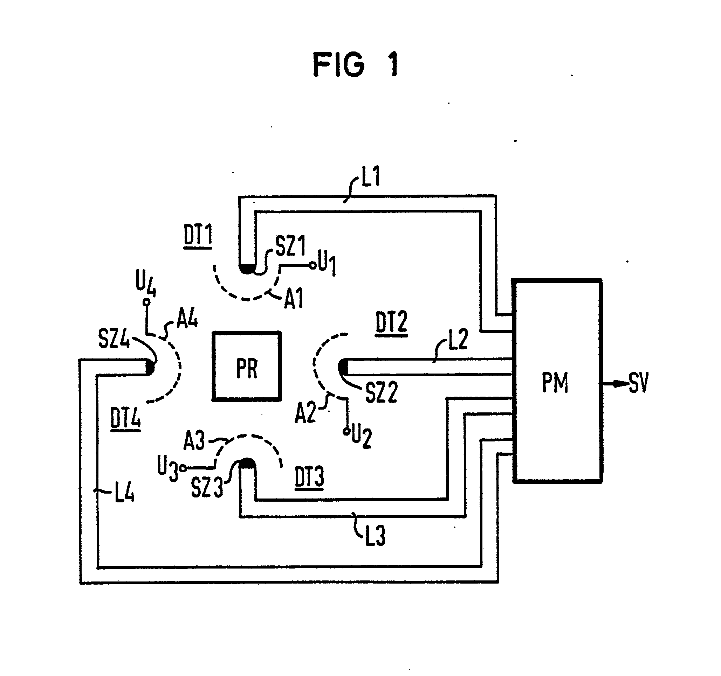

Das in Fig. 1 schematisch dargestellte Detektorsystem ist aus vier symmetrisch zur Probe PR angeordneten Einzeldetektoren DT1 bis DT4 aufgebaut. Jeder dieser Einzeldetektoren DT1 bis DT4 besteht aus einem Absaugnetz A1 bis A4 und einem Szintillator SZ1 bis SZ4, der über einen Lichtleiter L1 bis L4 an den gemeinsamen Photomultiplier PM angekoppelt ist. In diesem Photomultiplier PM werden die in den Szintillatoren SZ1 bis SZ4 von auftreffenden Sekundärelektronen erzeugten und in den Lichtleitern L1 bis L4 weitergeleiteten Lichtimpulsen in ein sekundäres elektrisches Signal umgewandelt, das man verstärkt einer Anordnung zur Signalverarbeitung SV zuführt. Während die Absaugnetze A1 bis A4 zur Ablenkung der niederenergetischen Sekundärelektronen in Richtung der Szintillatoren SZ1 bis SZ4 unabhängig voneinander mit Spannungen U1 bis U4 zwischen etwa -400 und 400 Volt beaufschlagt werden können, liegen die Szintilatoren SZ1 bis SZ4 üblicherweise auf hohem positiven Potential ($U_{SZ} \approx 10$ kV), um durch Nachbeschleunigung der Sekundärelektronen eine ausreichend hohe Lichtausbeute zu erzielen.

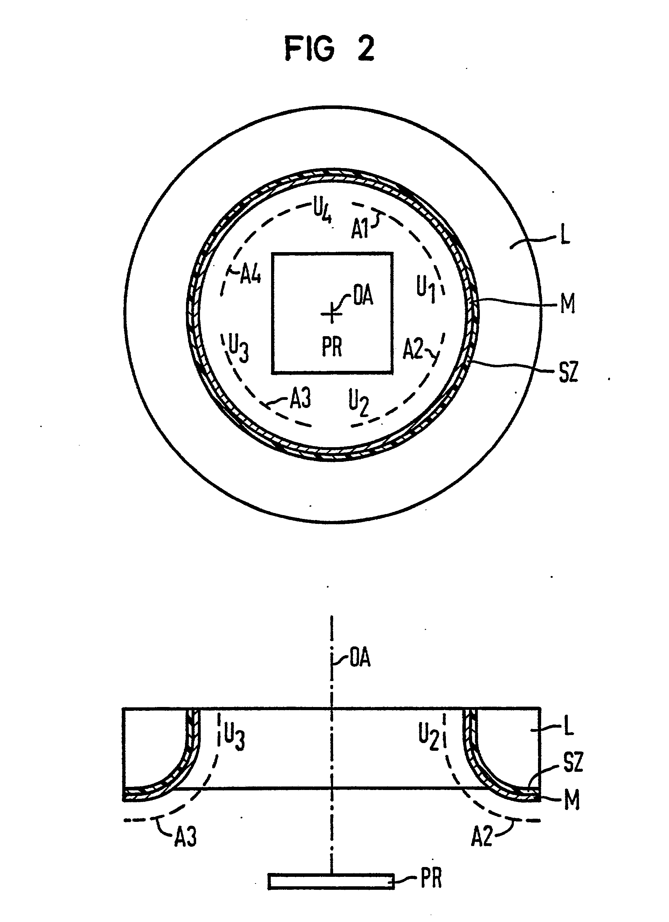

Ein weiteres symmetrisches Detektorsystem zum Nachweis von Sekundärelektronen ist in Fig. 2 dargestellt. Es besteht aus einem ringförmigen Lichtleiter L, auf dessen Innenseite ein Szintillator SZ aufgeschwemmt wurde. Zur Nachbeschleunigung der von den konzentrisch zur Symmetrieachse OA des Lichtleiters L angeordneten Absaugnetzen A1 bis A4 in Richtung der Szintillatorschicht SZ abgelenkten Sekundärelektronen ist eine dünne, auf den Szintillator SZ aufgedampfte Metallschicht M vorgesehen. Während diese Metallschicht M auf hohem postiven Potential von etwa 10 kV liegt, werden an die Absaugelektroden A1 bis A4 Spannungen U1 bis U4 zwischen etwa -400 und 400 Volt angelegt.

In einer der in den Fig. 1 und 2 dargestellten Detektorsysteme kann die bevorzugte Absaugrichtung der Sekundärelektronen in einfacher Weise dadurch eingestellt werden, daß man nur an eine der Absaugelektroden A1 bis A4 die gewünschte Absaugspannung U1 bis U4 anlegt. Die auf der Probe PR vom Primärelektronenstrahl ausgelösten Sekundärelektronen werden dann im Feld der betreffenden Elektrode A1 bis A4 nur in Richtung des zugeordneten Szintillators SZ1 bis SZ4 abgelenkt und beschleunigt.

Eine Änderung der Absaugrichtung erfolgt beispielsweise durch Umschalten der Absaugspannungen auf eine der anderen Elektroden.

Ein unsymmetrisches Absaugen der Sekundärelektronen von der Probe PR ist auch einfach dadurch erreichbar, daß man zwei benachbarte Absaugelektroden abwechselnd mit Spannung beaufschlagt. Das periodische Umschalten der Spannungen sollte hierbei innerhalb einer Zeitspanne vorgenommen werden, die sehr viel kleiner als die Verweildauer des Primärelektronenstrahls auf dem jeweiligen Meßpunkt der Probenoberfläche ist. Bei diesem Spannungswechsel ändert sich natürlich auch die Richtung, in der die Sekundärelektronen abgelenkt werden, periodisch mit der Umschaltfrequenz. Dieser Richtungswechsel erfolgt allerdings so schnell, daß im zeitlichen Mittel eine bestimmte Absaugrichtung durch eine geeignete Anpassung der Amplitude der an benachbarten Elektroden anliegenden Spannungen und der Zeiten, innerhalb der diese Spannungen an den jeweiligen Elektroden anliegen, eingestellt und verändert werden kann.

Es ist selbstverständlich auch möglich die einzelnen Absaugelektroden nacheinander mit Spannungen U1 bis U4 so anzusteuern, daß sich oberhalb der Probe PR ein zeitlich veränderliches elektrisches Feld aufbaut, das die Richtung in die die Sekundärelektronen abgesaugt werden, in einer Ebene senkrecht zur Primärstrahlrichtung mit konstanter Umlaufsfrequenz dreht. Um im zeitlichen Mittel wieder eine bevorzugte Absaugrichtung über die Höhe der Spannungen U1 bis U4 und die Zeitspanne, innerhalb der diese Spannungen U1 bis U4 an den jeweiligen Elektroden A1 bis A4 anliegen, einstellen und verändern zu können, muß das Umschalten der Spannung innerhalb von Zeiten erfolgen, die klein im Vergleich zur Verweildauer des Primärelektronenstrahls auf dem jeweiligen Punkt der Probenoberfläche sind.

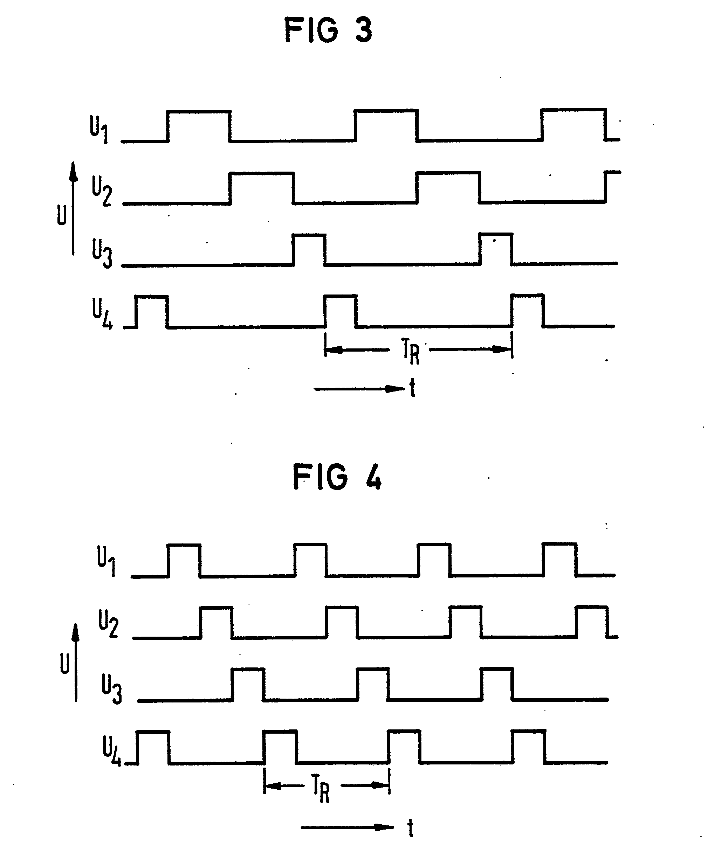

Zur Erzeugung eines die Absaugrichtung der Sekundärelektronen mit konstanter Umlauffrequenz drehenden elektrischen Feldes kann man beispielsweise die in Fig. 3 dargestellten Spannungsverläufe U1 bis U4 an die entsprechenden Absaugelektroden A1 bis A4 einer der Detektorsysteme nach Fig. 1 oder 2 anlegen. Aufgetragen ist die Spannung U an den Absaugelektroden A1 bis A4 in Abhängigkeit von der Zeit, wobei für alle Spannungen U1 bis U4 jeweils die gleiche Amplitude angenommen wurden.

Dieser Spannungsverlauf an den Absaugelektroden A1 bis A4 führt zu einem zeitlich veränderlichen elektrischen Feld, das die Richtung, in der man die Sekundärelektronen von der Probe absaugt, mit der durch die Periodendauer $T_R$ vorgegebenen Umlaufsfrequenz $f_R = T_R^{-1}$ dreht. Diese Drehung erfolgt wegen des gewählten Spannungsverlaufes allerdings nicht kontinuierlich. Außerdem sind auch die Zeitintervalle, innerhalb deren eine Änderung der Absaugrichtung erfolgt, während eines Umlaufes aufgrund der an den Elektroden A3 und A4 anliegenden Spannungen U3 bzw. U4 nicht konstant, so daß im zeitlichen Mittel mehr Sekundärelektronen in den Detektoren DT1 und DT2 nachweisbar sind. Ein die Absaugrichtung drehendes elektrisches Feld kann man auch durch Anlegen der in Fig. 4 dargestellten Spannungen U1 bis U4 an die entsprechenden Absaugelektroden A1 bis A4 erzeugen. Bei diesem Ausführungsbeispiel sind dann außer der Umlaufsfrequenz $f_R = T_R^{-1}$ auch die Zeitintervalle, innerhalb deren eine Änderung der Absaugrichtung eintritt, während eines Umlaufes konstant, da an jeder der Absaugelektroden A1 bis A4 der gleiche Spannungsverlauf phasenverschoben anliegt. Ist nun die Periodendauer $T_R$ klein im Vergleich zur Verweildauer des Primärelektronenstrahls auf dem jeweiligen Meßpunkt der Probenoberfläche, so werden die Sekundärelektronen im zeitlichen Mittel symmetrisch und weitgehend winkelunabhäng abgesaugt. Da diese Symmetrie aber nur im zeitlichen Mittel vorliegt, das Absaugen der Sekundärelektronen aber in einem jeweils stark unsymmetrischen Feld erfolgt, werden auch die in Richtung der Mittelachse des Detektorsystems emittierten Sekundärelektronen abgelenkt und nachgewiesen.

Eine Anordnung zur Durchführung eines solches Verfahrens besteht im wesentlichen aus einer Spannungsquelle, einem elektronischen Schalter und einem den Schalter ansteuernden Frequenzgenerator, dessen Ausgangssignal die Umschaltung der Gleichspannung auf die einzelnen Absaugelektroden A1 bis A4 eines Detektorsystems nach Fig. 1 oder 2 bewirkt.

Werden im Unterschied zu den oben beschriebenen Verfahren vier jeweils um 90° phasenverschobene Sinusspannungen U1 bis U4 an die Absaugelektroden A1 bis A4 angelegt, so baut sich oberhalb der Probe PR ein zeitlich veränderliches elektrisches Feld auf, das die Absaugrichtung der Sekundärelektronen kontinuierlich mit der durch die Sinusspannung vorgegebenen Frequenz dreht. Bei genügend hoher Umlaufsfrequenz wird auch bei diesen Verfahren eine im zeitlichen Mittel symmetrisches und weitgehend winkelunabhängiges Absaugen der Sekundärelektronen von der Probe PR erreicht.

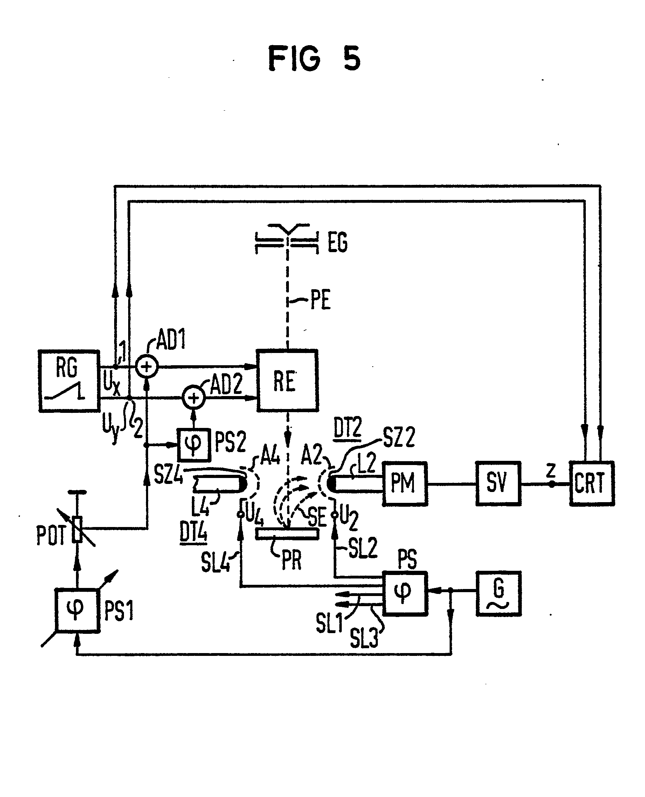

Eine Anordnung zur Durchführung dieses Verfahrens wird nachfolgend am Beispiel des in Fig. 5 dargestellten Meßsystems zur Abbildung der Oberflächentopographie einer Probe erläutert. Dieses Meßsystem besteht im wesentlichen aus einem Rasterelektronenmikroskop, einem Detektorsystem nach Fig. 1 oder 2 und einer aus dem Stand der Technik bekannten Anordnung zur Signalverarbeitung SV, der ein Sichtgerät CRT beispielsweise eine Kathodenstrahlröhre nachgeschaltet ist. Zur Abbildung der Probe PR wird ein fein gebündelter Primärelektronenstrahl PE in der elektronenoptischen Säule des Rastermikroskopes erzeugt. Diese elektronenoptische Säule weist neben einer Vielzahl in Fig. 5 nicht dargestellter Blenden und magnetischer Linsensysteme zur Formung und Fokussierung des Primärelektronenstrahls PE, eine im wesentlichen aus Kathode, Anode und Wehnelt-Elektrode bestehende Elektronenkanone EG eine Ablenkeinheit RE und einen der Ablenkeinheit RE zugeordneten Rastergenerator RG auf. Zum Nachweis der auf der Probe PR von den Primärelektronen PE ausgelösten Sekundärelektronen SE ist beispielsweise das in Fig. 1 dargestellte Detektorsystem DT vorgesehen. Der in den Detektoren DT1 bis DT4 (die Detektoren DT2 und DT3 wurden aus Gründen der Übersichtlichkeit nicht dargestellt) nachweisbare, in seiner Intensität infolge des unterschiedlichen Material- oder Topographiekontrastes schwankende Sekundärelektronenstrom erzeugt in den Szintillatoren SZ1 bis SZ4 Lichtimpulse, die dem gemeinsamen Photomultiplier PM über die Lichtleiter L1 bis L4 zugeführt und hier in ein sekundäres elektrisches Signal umgewandelt werden. Dieses Sekundärelektronensignal wird in der Signalverarbeitung SV weiter verstärkt, eventuell einer Tiefpaßfilterung zur Verbesserung des Signal-Rausch-Verhältnisses unterworfen und anschließend dem Eingang Z zur Steuerung der Intensität des Schreibstrahles des Sichtgerätes CRT zugeführt. Die x- und y-Ablenkeinrichtungen dieses Sichtgerätes CRT werden vom Rastergenerator RG über dessen Ausgänge 1 und 2 angesteuert, wobei man die an diesen Ausgängen auftretenden x- und y-Ablenkspannungen $U_x$ bzw. $U_y$ auch den entsprechenden Eingängen der Ablenkeinheit RE zuführt. Hierdurch wird eine synchrone Ablenkung des Primärstrahls PE über die Probenoberfläche und des Schreibstrahls des Sichtgerätes CRT über den Bildschirm erreicht. Zur Erzeugung eines im zeitlichen Mittel mit konstanter Umlaufsfrequenz $f_R$ und Drehgeschwindigkeit $2 \pi f_R$ rotierenden elektrischen Feldes oberhalb der Probe PR ist ein Sinusspannungen der Frequenz $f_R$ liefernder Signalgenerator G und ein Phasenschieber PS (beispielsweise ein Widerstands-Kondensatornetzwerk) vorgesehen, an dessen vier, mit den einzelnen Absaugelektroden A1 bis A4 über die Signalleitung SL1 bis SL4 verbundenen Ausgängen jeweils um 90° gegeneinander phasenverschobene Sinusspannungen $U_1$ bis $U_4$ anliegen. Ein im zeitlichen Mittel symmetrisches Absaugen der Sekundärelektronen SE ist immer dann gewährleistet, wenn die für einen Umlauf des elektrischen Feldes benötigte Zeit klein gegenüber der Verweildauer des Primärelektronenstrahls PE auf dem Meßpunkt gewählt wird.

Zur Korrektur der durch das zeitlich veränderliche Absaugfeld des Detektorsystems verursachten Abweichungen des Primärelektronenstrahles PE von seiner Sollposition auf der Probe PR ist beispielsweise eine aus einem regelbaren Phasenschieber PS1, einem Potentiometer POT und zwei zwischen den Ausgängen 1 bzw. 2 des Rastergenerators RG und den entsprechenden Eingängen der Ablenkeinheit RE angeordneten Addierern AD1 bzw. AD2 bestehenden Schaltungsanordnung vorgesehen. Mit dieser Schaltungsanordnung wird über die Ablenkeinheit RE ein zusätzliches Ablenkfeld erzeugt, das die Primärelektronen PE jeweils in die der momentanen Absaugrichtung der Sekundärelektronen SE entgegengesetzten Richtung beschleunigt. Um dies zu erreichen, ist der Ausgang des Signalgenerators G über den regelbaren Phasenschieber und das Potentiometer POT auch mit den Plus-Eingängen der Addierer AD1 bzw. AD2 verbunden, wobei zwischen den die y-Ablenkspannungen $U_y$ beeinflussenden Addierer AD2 und dem Potentiometer POT noch ein Phasenschieber PS2 angeordnet ist. Die Phasenlage des bezüglich des elektrischen Absaugfeldes der Detektoranordnung entgegenwirkenden Ablenkfeldes der Ablenkeinheit RE bzw. dessen Amplitude ist über den Phasenschieber PS1 bzw. das Potentiometer POT einstellbar.

Das erfindungsgemäße Verfahren wurde bisher am Beispiel räumlich symmetrischer Detektorsysteme erläutert. Es ist selbstverständlich auch bei Verwendung räumlich unsymmetrischer Anordnungen anwendbar. Um auch in solchen Fällen ein im zeitlichen Mittel symmetrisches Absaugen der Sekundärelektronen von der Probe zu erreichen, müssen an die weiter von der Strahlachse entfernten Ablenkelektroden entsprechend höhere Absaugspannungen angelegt werden.

Nach einer weiteren Ausgestaltung der Erfindung wird die Spannungsamplitude an den Absaug- bzw. Drückelektroden und die Zeiten, innerhalb deren diese Spannungen an den jeweiligen Elektroden anliegen, in Abhängigkeit von der Position des Primärelektronenstrahles auf der Probe gesteuert. Dadurch lassen sich auch bei sehr großflächigen Proben über die gesamte Probenoberfläche hinweg gleichmäßige Detektionsbedingungen erreichen.

Das erfindungsgemäße Verfahren ist selbstverständlich auch in einem Spektrometer, wie es beispielsweise aus der Veröffentlichung von H.P. Feuerbaum in SEM/ 1979/1, SEM Inc, ANF O'Hare, IL 60666, S. 285 bis 296, oder der amerikanischen Patentschrift 4 464 571 bekannt ist, anwendbar. Diese vorzugsweise für quantitative Potentialmessungen in hochintegrierten Schaltungen eingesetzten Gegenfeld-Spektrometer bestehen üblicherweise aus einer Absaugelektrode, einer oder mehreren Gegenfeldelektroden und einer Ablenkeinheit zur Beschleunigung der Sekundärelektronen in Richtung eines Szintillators. Aufgrund des unsymmetrischen Aufbaus der Ablenkeinheiten werden die auf achsenfernen Bahnen in der Nähe der Gehäuseteile laufenden Sekundärelektronen im Feld der Ablenkelektroden nur schwach abgelenkt und tragen daher nicht zu dem in einem Detektor gemessenen Signal bei. Um ein symmetrisches Absaugen der Sekundärelektronen oberhalb der Gegenfeldelektroden zu erreichen, kann ein entsprechend modifiziertes Detektorsystem nach Figur 1 oder 2 als Ablenkelement eingesetzt und beispielsweise mit den in Figur 4 dargestellten Spannungen beaufschlagt werden.

Bezugszeichenliste

A1 bis A4 Absaug- bzw. Ablenkelektroden
AD1 bis AD2 Addierer
CRT Sichtgerät
DT1 bis DT4 Detektorsysteme
EG Elektronenkanone
G Signalgenerator
L/L1 bis L4 Lichtleiter
M Metallschicht
OA Symmetrieachse
PE Primärelektronen
PM Fotomultiplier
POT Potentiometer
PR Probe
PS/PS1/PS2 Phasenschieber
RE Ablenkeinheit
RG Rastergenerator
SE Sekundärelektronen
SL1 bis SL4 Signalleitungen
SV Signalverarbeitung
SZ/SZ1 bis SZ4 Szintillatoren
U/U1 bis U4 Spannungen an den Absaugelektroden
Ux/Uy Ablenkspannungen
Z Steuereingang Intensität der CRT

**Patentansprüche**

1. Verfahren zum Nachweis der auf einer Probe (PR) von einem primären Korpuskularstrahl (PE) ausgelösten Sekundärkorpuskeln (SE) mit einem oberhalb der Probe (PR) angeordneten Detektorsystem (DT1 bis DT4), das einen oder mehrere für Sekundärkorpuskeln (SE) sensitive Bereiche (SZ, SZ1 bis SZ4) sowie eine Vorrichtung (A1 bis A4) zur Erzeugung eines die Sekundärkorpuskeln (SE) in Richtung des Bereichs (SZ) oder der Bereiche (SZ1 bis SZ4) beschleunigenden Feldes aufweist, dadurch gekennzeichnet, daß dem die Sekundärkorpuskeln (SE) beschleunigenden Feld eine Zeitabhängigkeit derart aufgeprägt wird, daß die Sekundärkorpuskeln (SE) periodisch in verschiedene Richtung abgelenkt und in dem Bereich (SZ) oder den Bereichen (SZ1 bis SZ4) nachgewiesen werden und daß die Zeitintervalle, innerhalb deren man Änderungen der Ablenkrichtung vornimmt, höchstens gleich der Verweildauer des primären Korpuskularstrahls (PE) auf einem Punkt der Probe (PR) gewählt werden.

2. Verfahren nach Anspruch 1, dadurch gekennzeichnet, daß die Vorrichtung zur Erzeugung des die Sekundärkorpuskeln (SE) beschleunigenden Feldes aus mehreren Elektrodenanordnungen (A1 bis A4) besteht und daß die Elektrodenanordnungen (A1 bis A4) mit zeitabhängigen Signalen (U1 bis U4) angesteuert werden.

3. Verfahren nach Anspruch 1 oder 2, dadurch ekennzeichnet, daß die Elektrodenanordnungen (A1 bis A4) mit Signalen (U1 bis U4) derselben Frequenz ($f_R$) angesteuert werden, daß die Signale (U1 bis U4) den Elektrodenanordnungen phasenverschoben derart zugeführt werden, daß ein mit festem Drehsinn umlaufendes Feld erzeugt wird, dessen Umlaufsfrequenz der Frequenz ($f_R$) der Signale (U1 bis U4) entspricht und daß die Frequenz ($f_R$) derart gewählt wird, daß die Umlaufsperiode ($T_R$ = $1/f_R$) höchstens gleich der Verweildauer des primären Korpuskularstrahls (PE) auf einem Punkt der Probe (PR) ist.

4. Verfahren nach Anspruch 2 oder 3, dadurch gekennzeichnet, daß die Elektrodenanordnungen (A1 bis A4) symmetrisch zu einer Strahlachse (OA) des primären Korpuskularstrahls (PE) angeordnet und mit Signalen (U1 bis U4) angesteuert werden, die dieselbe Zeitabhängigkeit und Amplitude aufweisen.

5. Verfahren nach Anspruch 2 oder 3, dadurch gekennzeichnet, daß die Zeitabhängigkeit und/oder die Amplitude der die Elektrodenanordnungen (A1 bis A4) ansteuernden Signale (U1 bis U4) so gewählt werden, daß die Sekundärkorpuskeln (SE) im zeitlichen Mittel bevorzugt in einer Richtung abgelenkt werden.

6. Verfahren nach einem der Ansprüche 2 bis 5, dadurch gekennzeichnet, daß die Elektrodenanordnungen (A1 bis A4) ansteuernden Signale (U1 bis U4) einen sinusförmigen Verlauf aufweisen.

7. Verfahren nach einem der Ansprüche 2 bis 5, dadurch gekennzeichnet, daß die die Elektrodenanordnungen (A1 bis A4) ansteuernden Signale (U1 bis U4) einen rechteckförmigen Verlauf aufweisen.

8. Anordnung zum Nachweis der auf einer Probe (PR) von einem primären Korpuskularstrahl (PE) ausgelösten Sekundärkorpuskeln (SE) mit einem oberhalb der Probe (PR) angeordneten Detektorsystem (DT1 bis DT4), das einen oder mehrere für Sekundärkorpuskeln (SE) sensitive Bereiche (SZ, SZ1 bis SZ4) aufweist, wobei diesem Bereich (SZ) oder diesen Bereichen (SZ1 bis SZ4) Elektrodenanordnungen (A1 bis A4) zur Ablenkung und Beschleunigung der Sekundärkorpuskeln (SE) zugeordnet sind, gekennzeichnet durch einen Signalgenerator (G) und eine dem Signalgenerator (G) nachgeschaltete Vorrichtung (PS) zur selektiven Ansteuerung der Elektrodenanordnungen (A1 bis A4) mit zeitabhängigen Signalen (U1 bis U4).

9. Anordnung nach Anspruch 8, gekennzeichnet durch einen elektronischen Schalter als Vorrichtung zur selektiven Ansteuerung.

10. Anordnung nach Anspruch 8, gekennzeichnet durch einen Phasenschieber (PS) als Vorrichtung zur selektiven Ansteuerung.

11. Anordnung nach einem der Ansprüche 8 bis 10, dadurch gekennzeichnet, daß das Detektorsystem aus mehreren Einzeldetektoren (DT1 bis DT4) besteht, wobei den Einzeldetektoren (DT1 bis DT4) jeweils eine mit der Vorrichtung (PS) zur selektiven Ansteuerung verbundene Elektrode (A1 bis A4) zur Ablenkung und Beschleunigung der Sekundärkorpuskeln (SE) zugeordnet ist.

12. Anordnung nach einem der Ansprüche 8 bis 10, dadurch gekennzeichnet, daß das Detektorsystem einen ringförmigen Lichtleiter (L), eine auf der Innenfläche des Lichtleiters (L) aufgebrachte Szintillatorschicht (SZ), eine auf der Szintillatorschicht (SZ) aufgebrachte Metallschicht (M) und mehrere konzentrisch zu einer Symmetrieachse (OA) des Lichtleiters (L) angeordnete Elektroden (A1 bis A4) zur Beschleunigung und Ablenkung der Sekundärkorpuskeln (SE) aufweist.

**Revendications**

1. Procédé pour détecter des corpuscules secondaires (SE) qui sont émis par un échantillon (P1) sous l'impact d'un faisceau corpusculaire primaire (PE), à l'aide d'un système de détecteurs (DT1 à DT4), qui est disposé au-dessus de l'échantillon (PR) et comporte une ou plusieurs zones sensibles (SZ, SZ1 à SZ4), pour les corpuscules secondaires (SE), ainsi qu'un dispositif (A1 à A4) servant à produire un champ accélérant les particules corpusculaires (SE) en direction de la zone (SZ) ou des zones (SZ1 à SZ4), caractérisé en ce qu'on rend le champ accélérant les corpuscules secondaires (SE), dépendant du temps en déviant périodiquement les corpuscules secondaires (SE) dans différentes directions et en les détectant dans la zone (SZ) ou dans les zones (SZ1 à SZ4), et qu'on choisit un intervalle de temps, pendant lequel on réalise des modifications du sens de déviation, au maximum égal à la durée de séjour du faisceau corpusculaire primaire (PE) en un point de l'échantillon (PR).

2. Procédé suivant la revendication 1, caractérisé par le fait que le dispositif servant à produire le champ accélérant les corpuscules secondaires (SE) est constitué par plusieurs dispositifs d'électrodes (A1 à A4) et que les dispositifs d'électrodes (A1 à A4) sont commandés par des signaux (U1 à U4), qui sont fonction du temps.

3. Procédé suivant la revendication 1 ou 2, caractérisé par le fait que les dispositifs d'électrodes (A1 à A4) sont commandés par des signaux (U1 à U4) possédant la même fréquence ($f_R$), qu'on envoie les signaux (U1 à U4), en les déphasant, aux dispositifs a électrodes, qu'on forme un champ rotatoire avec un sens de rotation fixe et dont la fréquence de rotation correspond à la fréquence ($f_R$) des signaux (U1 à U4), et qu'on choisit la fréquence ($f_R$), de manière que la période de rotation ($T_R=1/f_R$) soit égale au maximum à la durée de séjour du faisceau corpusculaire primaire (PE) en un point de l'échantillon (PR).

4. Procédé suivant la revendication 2 ou 3, caractérisé par le fait que les dispositifs d'électrodes (A1 à A4) sont disposés symétriquement par rapport à un axe (OA) du faisceau corpusculaire primaire (PE), et sont commandés par des signaux (U1 à U4) qui possèdent la même dépendance par rapport au temps et la même amplitude.

5. Procédé suivant la revendication 2 ou 3, caractérisé par le fait que la dépendance vis-à-vis du temps et/ou l'amplitude des signaux (U1 à U4), qui commandent les dispositifs d'électrodes (A1 à A4), sont choisies de telle sorte que les corpuscules secondaires (SE) sont déviés de préférence dans une direction, en moyenne dans le temps.

6. Procédé suivant l'une des revendications 2 à 5, caractérisé par le fait que les signaux (U1 à U4) qui commandent les dispositifs d'électrodes (A1 à A4), possèdent une variation sinusoïdale.

7. Procédé suivant l'une des revendications 2 à 5, caractérisé par le fait que les signaux (U1 à U4) qui commandent les dispositifs d'électrodes (A1 à A4), possèdent une allure rectangulaire.

8. Dispositif pour détecter les corpusculaires secondaires (SE), émis par un échantillon (PR) sous l'impact d'un faisceau corpusculaire primaire (PE), et comportant un système de détecteur (DT1 à DT4) qui est disposé au-dessus de l'échantillon (PR) et possède une ou plusieurs zones (SZ, SZ1 à SZ4) sensibles pour les corpuscules secondaires (SE), des dispositifs d'électrodes (A1 à A4) servant à faire dévier et accélérer les corpuscules secondaires (SE) étant associés à cette zone (SZ) ou à ces zones (SZ1 à SZ4), caractérisé par un générateur de signaux (G) et un dispositif (PS) branché en aval du générateur de signaux (G) servant à commander de façon sélective ledit dispositif d'électrodes (A1 à A4) avec des signaux (U1 à U4) qui sont fonction du temps.

9. Dispositif suivant la revendication 8, caractérisé par un interrupteur électronique en tant que dispositif pour réaliser la commande sélective.

10. Dispositif selon la revendication 8, caractérisé par un déphaseur (PS) en tant que dispositif servant à réaliser la commande sélective.

11. Dispositif selon l'une des revendications 8 à 10, caractérisé en ce que le système de détecteurs est constitué par plusieurs détecteurs individuels (DT1 à DT4), une électrode (A1 à A4) qui est reliée au dispositif (PS) servant à l'attaque sélective étant respectivement associée aux détecteurs individuels (DT1 à DT4), pour faire dévier et accélérer les corpuscules secondaires (SE).

12. Dispositif selon l'une des revendications 8 à 10, caractérisé par le fait que le système de détecteurs comporte un guide optique annulaire (L), une couche formant scintillateur (SZ), déposée sur la face intérieure du guide optique (L), une couche métallique (M) déposée sur la couche formant scintillateur (SZ), et plusieurs électrodes (A1 à A4) disposées concentriquement par rapport à un axe de symétrie (OA) du guide optique (L) et servant à accélérer et à faire dévier les corpuscules secondaires (SE).

**Claims**

1. Method for detecting secondary particles (SE) triggered on a specimen (PR) by a primary particle beam (PE), using a detector system (DT1 to DT4), which is arranged above the specimen (PR) and which exhibits one or several regions (SZ, SZ1 to SZ4) which are sensitive to secondary particles (SE) and a device (A1 to A4) for generating a field which accelerates the secondary particles (SE) in the direction of the region (SZ) or the regions (SZ1 to SZ4), characterized in that a time dependence is impressed on the field accelerating the secondary particles (SE), in such a manner that the secondary particles (SE) are periodically deflected in various directions and are detecting the region (SZ) or the regions (SZ1 to SZ4), and that the time intervals within which changes in the direction of deflection are carried out are selected to be, at the most, equal to the dwell time of the primary particle beam (PE) on one point of the specimen (PR).

2. Method according to claim 1, characterized in that the device for generating the field accelerating the secondary particles (SE) consists of several electrode arrangements (A1 to A4) and that the electrode arrangements (A1 to A4) are driven with time-dependent signals (U1 to U4).

3. Method according to claim 1 or 2, characterized in that the electrode arrangements (A1 to A4) are driven with signals (U1 to U4) of the same frequency ($f_R$), that the signals (U1 to U4) are supplied phase-shifted to the electrode arrangements, in such a manner that a field rotating with a fixed direction of rotation is generated, the frequency of rotation of which corresponds to the frequency ($f_R$) of the signals (U1 to U4) and that the frequency ($f_R$) is selected in such a manner that the period of rotation ($T_R = 1/f_R$) is, at the most, equal to the dwell time of the primary particle beam (PE) on one point of the specimen (PR).

4. Method according to claim 2 or 3, characterized in that the electrode arrangements (A1 to A4) are arranged symmetrically with respect to a beam axis (OA) of the primary particle beam (PE) and are driven with signals (U1 to U4) which exhibit the same time-dependence and amplitude.

5. Method according to claim 2 or 3, characterized in that the time-dependence and/or the amplitude of the signals (U1 to U4) driving the electrode arrangements (A1 to A4) are selected in such a manner that the secondary particles (SE) are preferably deflected in one direction averaged in time.

6. Method according to one of claims 2 to 5, characterized in that the signals (U1 to U4) driving the electrode arrangements (A1 to A4) exhibit a sinusoidal characteristic.

7. Method according to one of claims 2 to 5, characterized in that the signals (U1 to U4) driving the electrode arrangements (A1 to A4) exhibit a rectangular characteristic.

8. Arrangement for detecting secondary particles (SE) triggered on a specimen (PR) by a primary particle beam (PE), comprising a detector system (DT1 to DT4) which is arranged above the specimen (PR) and which exhibits one or several regions (SZ, SZ1 to SZ4) which are sensitive to secondary particles (SE), electrode arrangements (A1 to A4) for deflecting and accelerating the secondary particles (SE) being allocated to this region (SZ) or these regions (SZ1 to SZ4), characterized by a signal generator (G) and a device (PS) following the signal generator (G) for selectively driving the electrode arrangements (A1 to A4) with time-dependent signals (U1 to U4).

9. Arrangement according to claim 8, characterized by an electronic switch as device for the selective driving.

10. Arrangement according to claim 8, characterized by a phase shifter (PS) as device for the selective driving.

11. Arrangement according to one of claims 8 to 10, characterized in that the detector system consists of several individual detectors (DT1 to DT4), one electrode (A1 to A4) for deflecting and accelerating the secondary particles (SE), which connected to the device (PS) for the selective driving, in each case being allocated to the individual detectors (DT1 to DT4).

12. Arrangement according to one of claims 8 to 10, characterized in that the detector system exhibits an annular optical waveguide (L), a scintillator layer (SZ) which is applied to the inside surface of the optical waveguide (L), a metal layer (M) which is applied to the scintillator layer (SZ) and several electrodes (A1 to A4) for accelerating and deflecting the secondary particles (SE), which are arranged concentrically with respect to an axis of symmetry (OA) of the optical waveguide (L).

# FIG 1

# FIG 2

FIG 3

FIG 4

# FIG 5